# EUROPÄISCHE PATENTSCHRIFT

(11) **EP 0 359 856 B1**
(45) Veröffentlichungstag und Bekanntmachung des Hinweises auf die Patenterteilung: **22.12.1993**
(21) Anmeldenummer: 88115529.5
(22) Anmeldetag: 22.09.1988
(51) Int. Cl.: H01G 1/035, H01C 13/02, H05K 5/00

(54) **Verfahren sowie Vorrichtung zum Umformen von Zylindrischen elektrischen Bauteilen**
Process and device for converting cylindrical electric components
Procédé et dispositif pour transformer des composants électriques cylindriques

(43) Veröffentlichungstag der Anmeldung: 28.03.1990
(73) Patentinhaber: Sillner, Georg, D-93197 Zeitlarn (DE)
(72) Erfinder: Sillner, Georg, D-93197 Zeitlarn (DE)
(74) Vertreter: Graf, Helmut, Dipl.-Ing.

(56) Entgegenhaltungen:
- DE-A- 3 337 416
- FR-A- 2 529 428
- FR-A- 2 555 356
- FR-A- 2 584 887

## Beschreibung

Die Erfindung bezieht sich auf ein Verfahren zum Umformen von zylindrischen, vorzugsweise kreiszylindrischen elektrischen Bauteilen in elektrische Bauelemente, deren Umfangsfläche wenigstens einen ebenen Flächenbereich bzw. -abschnitt aufweist.

Zylindrische elektrische Bauteile sind in verschiedensten Ausführungen (als Dioden, Widerstände, Kondensatoren usw.) bekannt und werden vielfach auch als "MELF" bezeichnet. Diese Bauteile gehören zu der Gruppe von sog. SMD-Bauteilen (Surface Mounted Devices) und werden u.a. zum Herstellen elektrischer Schaltungen unter Verwendung von Printplatten derart verarbeitet, daß diese Bauteile zum Bestücken der betreffenden Printplatte auf diese aufgesetzt und dort (beispielsweise durch einen Klebstoffauftrag) vorläufig fixiert werden. Die elektrische Verbindung dieser Bauteile mit den Leiterbahnen der Printplatte erfolgt dann in einem weiteren Verfahrensschritt durch Löten in der Weise, daß die Bauteile mit an ihren beiden Enden jeweils vorgesehenen Kontaktflächen direkt mit den Leiterbahnen der Printplatte verlötet sind. Nachteilig hierbei ist u.a., daß die zylindrischen Bauteile aufgrund ihrer Formgebung ohne die vorläufige Fixierung auf der Grundplatte leicht verrutschen bzw. verrollen, also die Fixierung (beispielsweise mit Hilfe eines Klebers) für eine ordnungsgemäße Bestückung einer Leiterplatte unbedingt erforderlich ist, wobei allerdings auch aufgrund der zylindrischen Formgebung der Bauteile eine solche Fixierung nicht immer in der erforderlichen Weise gewährleistet ist.

Bekannt ist es (DE-A- 33 37 416), bei der Herstellung elektrischer Bauteile mit einem zylinderförmigen Bauelementekörper an den beiden Enden dieses Körpers als Kontaktelemente Anschlußkappen durch Aufschieben und Krimpen zu befestigen, wobei jede Anschlußkappe einen quadratischen Außenquerschnitt aufweist. Nachteilig ist hierbei u.a., daß die Anschlußkappen sehr aufwendige, den Erfordernissen nach einer rationellen Fertigung nicht entsprechende Formteile sind.

Bekannt ist weiterhin auch (FR-A- 25 84 887), bei elektrischen Bauelementen an einem Körper beidendig jeweils einen teilzylinderförmigen Anschluß vorzusehen, wobei der Bauelementekörper entweder einen quadratischen Querschnitt aufweist, der so gewählt ist, daß das Bauelement mit den zylindrischen Anschlüssen auf den Leiterbahnen einer Printplatte aufliegt, oder aber mit sich an der Printplatte abstützenden nasenartigen Vorsprüngen versehen ist. In beiden Ausführungen stellt das bekannte Bauelement eine Sonderform dar, die nicht den heute üblicherweise mit vorhandenen Produktionsmitteln produzierten zylindrischen Bauteilen (MELF) entspricht.

Der Erfindung liegt die Aufgabe zugrunde, ein Verfahren bzw. eine Vorrichtung aufzuzeigen, mit dem bzw. mit der es in einfacher Weise möglich ist, zylindrische, vorzugsweise kreiszylindrische elektrische Bauteile in solche umzuwandeln, deren Umfangsfläche wenigstens einen ebenen Flächenbereich aufweist, um dadurch die Bestückung einer elektrischen Schaltung zu vereinfachen.

Zur Lösung dieser Aufgabe ist ein Verfahren entsprechend dem kennzeichnenden Teil des Patentanspruches 1 bzw. eine Vorrichtung entsprechend dem kennzeichnenden Teil des Patentanspruches 20 ausgebildet.

Dadurch, daß nach der Umformung bzw. Umwandlung elektrische Bauelemente erhalten werden, die an ihrer Umfangsfläche wenigstens einen ebenen Flächenbereich aufweisen, können diese Bauelemente, die ebenfalls SMD-Bauteile sind, wesentlich einfacher bei der Bestückung einer elektrischen Schaltung verarbeitet werden, d.h. die umgewandelten Bauelemente können mit dem wenigstens einen ebenen Flächenbereich auf die Leiterplatte aufgelegt werden, so daß auch schon ohne eine vorübergehende Fixierung vor dem Verlöten eine ordnungsgemäße Positionierung der Bauelemente und damit eine ordnungsgemäße Bestückung der Leiterplatte möglich ist. Durch den wenigstens einen ebenen Flächenberich ergibt sich aber auch die Möglichkeit einer wesentlich verbesserten Fixierung in solchen Fällen, in denen eine Fixierung vor dem Verlöten notwendig bzw. angestrebt ist.

Die auf die beiden Enden des umzuwandelnden elektrischen Bauteils aufgebrachten Metallplatten bilden bei dem umgeformten Bauelement die freiliegenden Kontaktflächen dieses Bauelementes.

Bei einer Ausführung der Erfindung werden die Platten aus Metall und die umzuwandelnden Bauteile in einen Form- oder Formierungsraum eingeschoben, in welchen beispiesweise anschließend auch die Masse aus elektrisch isolierendem Material eingebracht wird, die nach ihrem Aushärten bzw. Abbinden nicht nur das Bauteil nach dem Umformen zumindest teilweise umschließt, sondern auch den wenigstens einen ebenen Flächenbereich des umgeformten Bauelementes bildet. In diesem Formierungsraum können auch aus umzuformenden Bauteilen und Platten bestehende Rohlinge gebildet werden, die dann nach der Entnahme aus dem Formierungsraum in eine gesonderte Form zum Aufbringen der Masse aus elektrisch isolierendem Material eingebracht bzw. eingelegt werden.

Bei einer anderen Ausführungsform werden die Platten an wenigstens einem Trägerstreifen einer Arbeitsposition zugeführt und dort mit den Enden der umzuformenden Bauteile verbunden, wobei dann die so erhaltenen aus jeweils wenigstens einem Bauteil und zwei Platten bestehenden Rohlinge in eine Form zum Aufbringen der Masse aus elektrisch isolierendem Material eingebracht bzw. eingelegt werden.

Das umzuformende elektrische Bauteil kann ein MELF oder aber ein anderes, einen zylindrischen Körper aufweisendes Bauteil, z.B. eine auf einen Ferrit-Körper gewickelte Spule usw. sein, so daß es mit dem erfindungsgemäßen Verfahren bzw. mit der erfindungsgemäßen Vorrichtung beispielsweise auch möglich ist, Induktivitäten preiswert zu fertigen.

Weiterbildungen der Erfindung sind Gegenstand der Unteransprüche.

Die Erfindung wird im folgenden anhand der Figuren an einem Ausführungsbeispiel näher erläutert. Es zeigen:
- Fig. 1: in vereinfachter schematischer Darstellung und in Draufsicht eine Vorrichtung zum Umwandeln von Bauteilen (MELFs) in rechteckige bzw. quaderförmige Bauelemente;
- Fig. 2: in vereinfachter perspektivischer Darstellung eine Teilansicht der Vorrichtung nach Fig. 1;
- Fig. 3: einen Schnitt durch den zum Aufbringen der Ummantelung bzw. Masse aus isolierendem Material dienenden Kanal der Vorrichtung nach Fig. 1;
- Fig. 4: in vereinfachter perspektivischer Darstellung ein MELF-Bauteil vor der Umwandlung;
- Fig. 5: in vereinfachter perspektivischer Darstellung ein Bauelement nach der Umwandlung;
- Fig. 6: in ähnlicher Darstellung wie Fig. 5 ein weiteres Bauelement nach der Umwandlung;

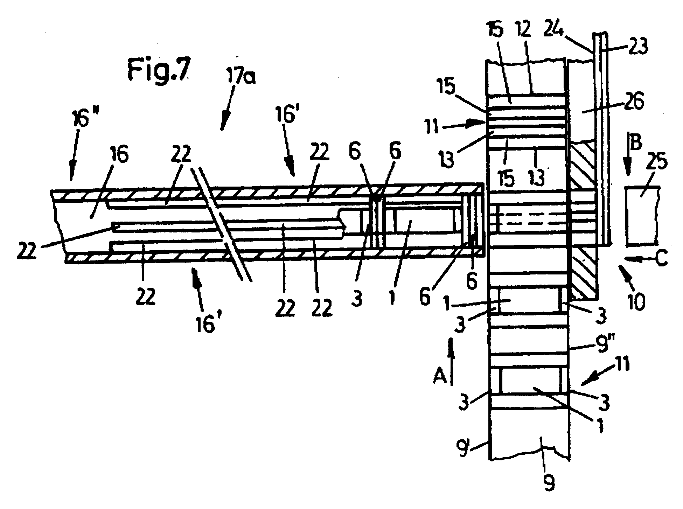

- Fig. 7: in vereinfachter Darstellung einen Längsschnitt durch einen Kanal zum Formen des Bauelementekörpers des Bauelementes nach Fig. 6 bei einer weiteren Ausführungsform der Vorrichtung zum Umwandeln von Bauteilen (MELFs) in rechteckige oder quadratische Bauelemente;
- Fig. 8: in Seitenansicht ein stangenartiger, aus Platten sowie aus umzuwandelnden Bauteilen (MELFs) bestehender Rohling;
- Fig. 9: in ähnlicher Darstellung wie Fig. 5 ein weiteres Bauelement nach der Umwandlung;
- Fig. 10 und 11: in vereinfachter schematischer Darstellung die Arbeitsstation einer weiteren Vorrichtung zum Umwandeln von Bauteilen (MELFs) in rechteckige oder quadratische Bauelemente gemäß Fig. 9, und zwar in Seitenansicht sowie in Draufsicht;
- Fig. 12: in vergrößerter Detaildarstellung das mit einer Platte verbundene Ende eines MELF-Bauteiles.

In den Figuren ist 1 ein MELF-Bauteil, welches einen kreiszylinderförmigen Bauelementekörper 2 aufweist, der an seinen beiden Enden bzw. Stirnseiten jeweils mit einer beispielsweise von einer Metallkappe gebildeten oder auf andere geeignete Weise erzeugten Kontaktierungsfläche 3 versehen ist. Derartige MELF-Bauteile, die aktive elektrische Bauteile (z.B. Dioden) oder aber passive elektrische Bauteile (z.B. Widerstände oder Kondensatoren) sein können, werden insbesondere zum Herstellen von elektrischen Schaltungen mit hoher Bauteildichte verwendet, wobei es üblich ist, das jeweilige MELF-Bauteil 1 an seinen Kontaktflächen 3 direkt beispielsweise mit den Leiterbahnen einer die Grundlage der Schaltung bildenden Printplatte durch Löten zu verbinden. Wegen der kreiszylinderförmigen Ausbildung der MELF-Bauteile 1 müssen diese mit ihrer Umfangsfläche auf der Printplatte aufliegend an dieser beispielsweise durch einen Klebstoffauftrag zumindest bis zum Anlöten fixiert werden, was umständlich ist und insbesondere auch wegen der Kreiszylinderform vielfach in der erforderlichen zuverlässigen Weise nicht oder nur erschwert möglich ist.

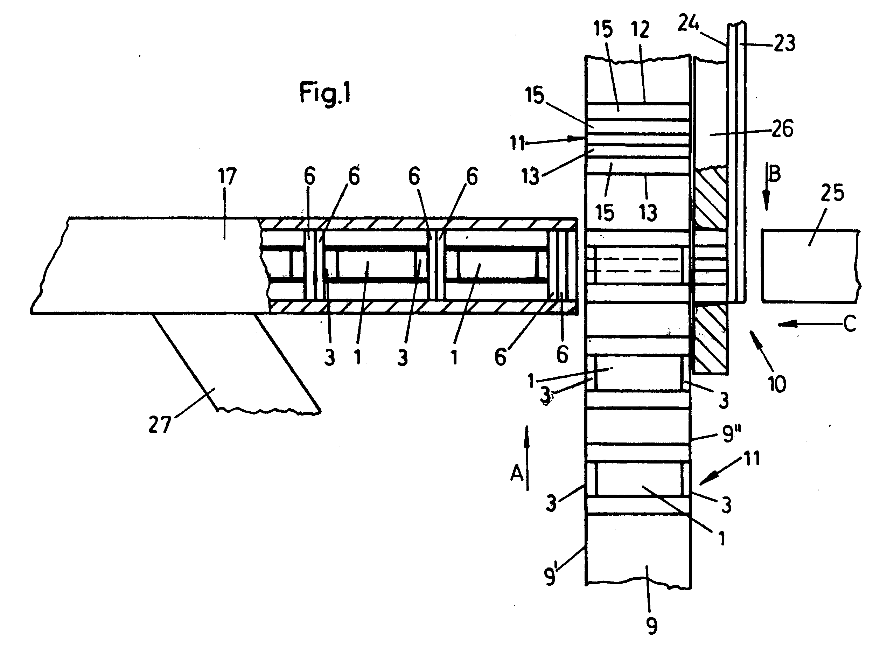

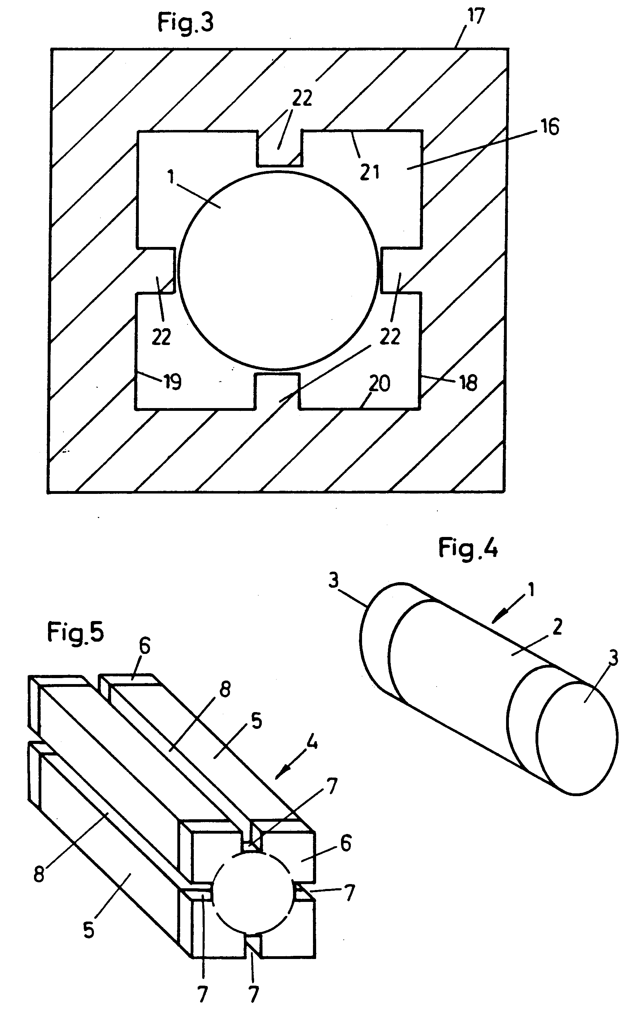

In den Figuren 1 bis 5 ist mit 4 ein Bauelement bezeichnet, welches nach dem erfindungsgemäßen Verfahren bzw. mit der erfindungsgemäßen Vorrichtung im einfachsten Fall aus einem MELF-Bauteil 1 hergestellt ist und welches bei der dargestellten Ausführungsform quaderförmig mit einem im wesentlichen quadratischen Querschnitt, d.h. mit einer Umfangsfläche hergestellt ist, die vier jeweils in Umfangsrichtung im rechten Winkel aneinander anschließende Flächenbereiche 5 aufweist. An seinen beiden Enden besitzt das Bauelement 4 jeweils eine im wesentlichen quadratische, aus einem Metallblech hergestellte und eine freiliegende Kontaktfläche bildende Platte 6 auf, deren Querschnittsabmessungen bzw. deren Seitenlängen etwas größer sind als der Querschnitt des MELF-Bauteiles 1. Jede Platte 6 ist an einer stirnseitigen Kontaktfläche 3 des MELF-Bauteiles 1 derart befestigt, das der Mittelpunkt der mit ihren Oberflächenseiten senkrecht zur Achse des MELF-Bauteiles 1 liegenden Platte 6 in der Achse des MELF-Bauteiles 1 liegt und zwischen der Platte 6 und der jeweiligen Kontaktfläche 3 auch eine elektrische Verbindung besteht. Zum Halten der Platten 6 an den Kontaktflächen 3 kann beispielsweise ein sogenannter "Leit-Kleber", d.h. ein Kleber verwendet werden, der nach dem Aushärten bzw. Abbinden auch eine galvanisch leitende Verbindung zwischen der jeweiligen Kontaktfläche 3 und der an dieser befestigten Platte 6 herstellt. Selbstverständlich sind zum Verbinden der Platten 6 mit den Kontaktflächen 3 des MELF-Bauteiles 1 auch andere Techniken denkbar. Die beiden Platten 6 sind weiterhin an den beiden Stirnseiten des MELF-Bauteiles 1 so befestigt, daß diese Platten jeweils die gleiche Orientierung aufweisen, d.h. jede Seitenkante einer Platte 6 parallel zu einer Seitenkante der anderen Platte 6 liegt. Der zwischen den beiden Platten 6 verbleibende Raum ist mit einer Masse aus elektrisch isolierendem Material (Kunststoff) ausgefüllt, die außerhalb der Platten 6 den das MELF-Bauteil 1 umschließenden Körper des Bauelementes 4 bildet und so geformt ist, daß das Bauelement 4 zwischen den beiden Platten 6 den über die gesamte Länge diese Bauelementes gleichbleibenden, die Flächenbereiche 5 aufweisenden quadratischen Querschnitt besitzt, der in seiner Form und Größe gleich dem Querschnitt der Platten 6 ist. Das Bauelement 4 wird in gleicher Weise wie das MELF-Bauteil 1 beim Herstellen einer Schaltung auf der verwendeten Print-Platte positioniert und mit Hilfe der die Kontaktflächen des Bauelementes 4 bildenden Platten 6 direkt mit den Leiterbahnen der Print-Platte verlötet.

Das Bauelement 4 ist somit ebenfalls ein SMD, allerdings sind durch die ebenen Flächenbereiche 5 das Positionieren des Bauelementes 4 auf der Leiterplatte sowie vor allem auch eine Aufrechterhaltung der jeweiligen Positionierung bis zur Herstellung der Lötverbindung wesentlich einfacher als bei dem MELF-Bauteil 1. Bei einem entsprechenden Handling der bestückten Print-Platte kann unter Umständen bei Verwendung der Bauelemente 4 auf deren vorläufige Fixierung auf der Print-Platte ganz verzichtet werden.

Wie insbesondere die Fig. 5 zeigt, weist jede Platte 6 vier Aussparungen 7 auf, von denen jeweils eine in der Mitte jeder Umfangsseite der betreffenden Platte 6 vorgesehen und zu dieser Umfangsseite hin offen ist. Die bei der dargestellten Ausführungsform im wesentlichen rechteckförmig ausgebildeten und in gleichmäßigen Winkelabständen um die Achse des MELF-Bauteiles 1 verteilt angeordneten Aussparungen besitzen jeweils eine solche Tiefe, daß jede Aussparung an der Umfangsfläche des MELF-Bauteiles 1 endet. Die, wie später noch erläutert wird, ein Hilfsmittel für die Herstellung des Bauelementes 4 erforderlichen Aussparungen 7 bilden jeweils das stirnseitig offene Ende einer an den Flächenbereichen 5 vorgesehenen, auch zum Umfang des Bauelementes 4 hin offenen Längsnut 8. Entsprechend der Anzahl der Aussparungen 7 ist an jedem Flächenbereich 5 eine derartige Längsnut 8 vorgesehen.

In den Fig. 1 bis 3 ist in schematischer Darstellung eine Vorrichtung wiedergegeben, die in besonders einfacher Weise die Umwandlung der MELF-Bauteile 1 in die Bauelemente 4 ermöglicht.

Diese Vorrichtung weist zunächst einmal ein Transportelement 9 auf, welches sich getaktet an einer Arbeitsposition 10 vorbeibewegt und die MELF-Bauteile 1 aus einem nicht näher dargestellten, eine Vielzahl solcher Bauteile aufweisenden Vorrat vereinzelt, d.h. nacheinander der Arbeitsposition 10 zuführt. Hierfür besitzt das Transportelement 9 mehrere, jeweils eine Aufnahme für ein MELF-Bauteil 1 bildende nutenförmige Ausnehmungen 11, die mit ihrer Längserstreckung senkrecht zur Bewegungsrichtung A des Transportelementes 9 orientiert sind und an den beiden in Bewegungsrichtung A verlaufenden Seiten 9' und 9'' des Transportelementes 9 sowie bei der dargestellten Ausführung auch an der Oberseite des Transportelementes 9 offen sind. Jede Ausnehmung 11 besitzt einen an den Querschnitt der Platten 6 angepaßten, d.h. bei der dargestellten Ausführungsform im wesentlichen quadratischen Querschnitt mit zwei die jeweilige Ausnehmung 11 seitlich begrenzenden und senkrecht zur Bewegungsrichtung A liegenden Flächen 12 und 13 sowie mit einer senkrecht zu den Flächen 12 und 13 liegenden und den Boden der jeweiligen Ausnehmung 11 bildenden Fläche 14. An jeder der Flächen 12 bis 14 ist ein in die Ausnehmung 11 hineinreichender und senkrecht zur Bewegungsrichtung A sich erstreckender leistenartiger Vorsprung 15 derart vorgesehen, daß die Anordnung, die die Vorsprünge 15 an den genannte Flächen relativ zueinander aufweisen gleich der Anordnung der Aussparungen 7 an drei aufeinander folgenden Umfangsseiten der Platten 6 ist. Durch die Vorsprünge 15 ist jedes an der Arbeitsposition 10 geförderte MELF-Bauteil 1 in der entsprechenden Ausnehmung 11 derart gehalten, daß dieses mit seiner Achse senkrecht zur Bewegungsrichtung A liegende Bauelement jeweils den gleichen Abstand von den Flächen 12 bis 14 aufweist. Senkrecht zur Bewegungsrichtung und in Richtung der Längserstreckung der Ausnehmungen 11 besitzt das Transportelement 9 zumindest im Bereich dieser Ausnehmungen eine Breite, die in etwa gleich der Länge der MELF-Bauteile 1 ist.

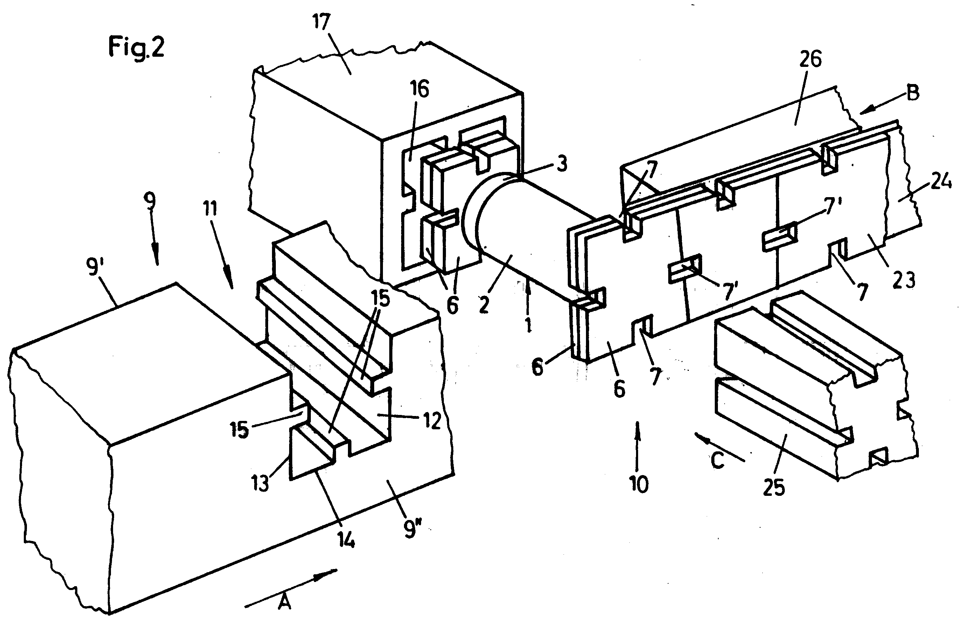

An der Arbeitsposition 10 endet an der einen Seite des Transportelementes 9, und zwar bei der für die Fig. 2 gewählten Darstellung an der hinteren Seite 9′ ein ortsfester Kanal 16, welcher einen Form- und Formierungsraum bildet, mit seiner Längserstreckung senkrecht zur Bewegungsrichtung A liegt und beispielsweise im Inneren eines rohrartigen Elementes 17 gebildet ist. Der Kanal 16 besitzt einen dem Querschnitt der Platten 6 angepaßten quadratischen Querschnitt, der von vier, jeweils rechtwinklig aneinander anschließenden Innenflächen 18 bis 21 gebildet ist. An jeder Innenfläche 18 ist ein in den Kanal 16 vorspringender, sich in Längsrichtung dieses Kanales erstreckender leistenartiger Vorsprung 22 vorgesehen, wobei diese Vorsprünge in ihrem Querschnitt sowie in ihrer Anordnung der Größe und Anordnung der Aussparungen 7 an den Platten 6 entsprechen, d.h. jeder Vorsprung 22 ist jeweils in der Mitte der zugehörigen Innenfläche 18 bis 21 vorgesehen und im Querschnitt senkrecht zur Längserstreckung des Kanales 16 so ausgebildet, daß er jeweils eine Ausnehmung 7 vollständig oder nahezu vollständig ausfüllt.

Die Anordnung des Transportelementes 9 relativ zum Kanal 16 sowie der Antrieb des Transportelementes 9 sind so gewählt, daß in jeder Stillstandsphase des getaktet angetriebenen Transportelementes 9 eine Ausnehmung 11 deckungsgleich mit den Kanal 16 derart liegt, daß sich nicht nur diese Ausnehmung mit ihren Flächen 12 bis 14 in den Innenflächen 18 bis 20 des Kanales 16 übergangslos fortsetzt, sondern sich auch jeder Vorsprung 15 in einem Vorsprung 22 des Kanales 16 fortsetzt.

Der Arbeitsposition 10 werden an der dem Kanal 16 gegenüber liegenden Seite 9'' mit Hilfe einer nicht näher dargestellten Fördereinrichtung zwei Materialstreifen 23 und 24 aus Metall in Richtung des Pfeiles B derart zugeführt, daß diese mit jeweils einer Oberflächenseite flächig gegeneinander anliegende Materialstreifen mit ihren Oberflächenseiten senkrecht zur der Längserstreckung der Ausnehmungen 11 orientiert sind. Die Materialstreifen 23 und 24, aus denen durch Abtrennen die Platten 6 erzeugt werden, sind an ihren in Förderrichtung B verlaufenden Längsseiten bereits mit den Aussparungen 7 vorgestanzt. In der Mitte weist jeder Materialstreifen eine Vielzahl von rechteckförmigen Aussparungen 7' auf, die eine sich in Längsrichtung des betreffenden Materialstreifens erstreckende Lochreihe oder Perforation bilden, wobei jede Aussparung 7' in Längsrichtung des betreffenden Materialstreifens zwischen zwei an den Längsseiten dieses Materialstreifens 23 bzw. 24 vorgesehenen Aussparungen 7 vorgesehen ist und außerdem in Längsrichtung des Materialstreifens eine Querschnittsabmessung besitzt, die doppelt so groß ist wie die Tiefe der Aussparungen 7. Die beiden Materialstreifen 23 und 24 werden der Arbeitsposition 10 weiterhin so zugeführt, daß diese auch in bezug auf die Ausnehmungen 7 und 7' deckungsgleich angeordnet sind.

An der Arbeitsposition 10 ist dort, wo die Materialstreifen 23 und 24 zugeführt werden, ferner eine Stanz- bzw. Schneideinrichtung vorgesehen, die im wesentlichen aus einen in Richtung senkrecht zur Bewegungsrichtung A hin- und herbewegbaren Stempel 25 sowie aus einem beispielsweise von einer Matrize gebildeten, ortsfesten Gegenhalter 26 besteht.

Die Arbeitsweise der Vorrichtung nach den Fig. 1 bis 3 läßt sich, wie folgt, beschreiben:
Jedes in eine Ausnehmung 11 des Transportelementes 9 angeordnete MELF-Bauteil 1 wird vor Erreichen der Arbeitsposition 10 an beiden stirnseitigen Kontaktflächen 3 mit einen Leitkleberauftrag versehen. Immer dann, wenn eine ein MELF-Bauteil 1 aufweisende Ausnehmung 11 die Arbeitsposition 10 erreicht hat, wird durch Bewegen des Stempels 25 in Richtung des Pfeiles C von jedem Materialstreifen 23 und 24 jeweils ein eine Platte 6 bildender vorderer Abschnitt abgetrennt, wobei das Abtrennen in der Mitte der Aussparungen 7' erfolgt. Die beiden so aus den Materialstreifen 23 und 24 hergestellten und paketartig aufeinander liegenden Platten 6 werden dann gegen die der Seite 9'' des Transportelementes 9 benachbarte Kontaktfläche 3 des MELF-Bauteiles 1 zur Anlage gebracht, wobei die aus dem Materialstreifen 24 gewonnene Platte 6 unmittelbar gegen die betreffende Kontaktfläche 3 des MELF-Bauteiles 1 anliegt und eine Klebeverbindung mit dieser Kontaktfläche 3 eingehen kann, während die aus den Materialstreifen 23 gewonnene Platte 6 nur durch flächige Berührung gegen die aus dem Materialstreifen 24 gewonnene Platte 6 anliegt. Durch weiteres Bewegen des Stempels 25 in Richtung des Pfeiles C wird dann das MELF-Bauteil 1 zusammen mit den beiden aus den Materialstreifen 23 und 24 gewonnenen Platten 6 in den Kanal 16 eingeschoben, wobei die Platten 6 durch die in die Aussparungen 7 eingreifenden Vorsprünge 15 bzw. 22 sowohl beim Bewegen entlang der Ausnehmung 11, als auch beim Bewegen innerhalb des Kanales 16 präzise geführt und gegen Verkippen bzw. Verkanten gesichert sind.

In dem nächsten Arbeitstakt, d.h. dann, wenn erneut eine Ausnehmung 11 des Transportelementes 9 die Arbeitsposition 10 erreicht hat, werden wieder aus den beiden Materialstreifen 23 und 24 zwei Platten 6 abgetrennt und zusammen mit dem betreffenden MELF-Bauteil 1 durch die Ausnehmung 11 in den Kanal 16 eingeschoben, wobei das MELF-Bauteil 1 mit seiner bei diesem Einschieben vorauseilenden und mit dem Leitkleber versehenen Stirnseite gegen diejenige Platte 6 zur Anlage kommt, die bei dem vorausgehenden Arbeitstakt aus dem Materialstreifen 23 gewonnen wurde. Es versteht sich, daß nach jedem Einschieben eines MELF-Bauteiles 1 und der beiden Platten 6 der Stempel 25 jeweils in seine Ausgangsstellung entgegen dem Pfeil C zurückbewegt wird.

In der beschriebenen Weise wird somit der Kanal 16 mit MELF-Bauteilen 1 und jeweils zwei zwischen jedem Bauteil liegenden Platten 6 aufgefüllt, wobei bei jedem Arbeitstakt die im Kanal 16 befindlichen MELF-Bauteile 1 und Platten 6 weitergeschoben werden. In den Kanal 16 mündet mit Abstand vom Transportelement 9 ein Zuführungskanal 27, über welchen die den Bauelementekörper des Bauelementes 4 bildende Kunstoffmasse zugeführt wird, so daß nach dem Passieren dieses Zuführungskanales 27 die zwischen den Platten 6 vorgesehenen MELF-Bauteile 1 mit der Kunststoffmasse ummantelt sind, wobei sich durch den Querschnitt des Kanales 16 auch die angestrebte Querschnittsform für die Bauelemente 4 ergibt. Mit Abstand von dem Zuführungskanal 27 weist der Kanal 16 einen Auslaß auf, an welchem die Bauelemente 4 dann nach dem Aushärten der Kunststoffmasse den Kanal 16 verlassen und beispielsweise mit Hilfe eines Transportelementes abgefördert werden können.

Das Transportelement 9 ist beispielsweise ein Transportband oder ein Transportriemen, bevorzugt ein in Richtung des Pfeiles A umlaufendes Rad, welches an seiner Umfangsfläche die Ausnehmungen 11 in gleichmäßigen Winkelabständen verteilt aufweist.

Das vorbeschriebene Verfahren bzw. die vorbeschriebene Vorrichtung können ebenso wie die nachfolgend noch beschriebenen Verfahren und Vorrichtungen auch zum Herstellen von Induktivitäten verwendet werden, wobei dann anstelle eines MELF-Bauteiles ein dem Bauelementekörper 2 entsprechender und zumindest teilweise aus ferromagnetischem Material bestehender sowie mit einer Wicklung versehener Körper verwendet wird.

Fig. 6 zeigt ein durch Umformung unter Verwendung der Platten 6 sowie des MELF-Bauteiles 1 erhaltenes Bauelement 4a, welches sich von dem Bauelement 4 dadurch unterscheidet, daß das Bauelement 4a die Längsnuten 8 nicht besitzt, d.h. das Bauteil 4a ist an seinen Flächenbereichen 5 völlig eben ohne Unterbrechung durch die jeweilige Längsnut 8 ausgebildet, wobei sich die das MELF-Bauteil 1 einschließende und die Flächenbereiche 5 bildende Kunststoffmasse auch in die Aussparungen 7 der beiden Platten 6 hineinerstreckt bzw. diese Aussparungen ausfüllt. Das Bauelement 4a, welches sich wegen der durch die Längsnuten 8 nicht unterbrochenen Flächenbereiche 5 insbesondere auch für eine Verarbeitung mit Saug-Greifern eignet, wird in gleicher Weise wie das Bauelement 4 mit Hilfe der Vorrichtung nach den Fig. 1-3 und damit in der oben beschriebenen Weise durch Umformen hergestellt, allerdings mit dem Unterschied, daß das die Umfangsfläche, d.h. die Flächenbereiche 5 des Bauelementes 4a formende Formwerkzeug die stegartigen Vorsprünge 22 nicht aufweist.

Zum Herstellen des Bauelementes 4a werden die aus den Materialstreifen 23 und 24 ausgestanzten Platten 6 sowie die über das Transportelement 9 zugeführten MELF-Bauelemente in gleicher Weise, wie dies für die Ausführungsform nach den Fig. 1-5 beschrieben wurde, jeweils nacheinander in den Kanal 16 des rohrartigen Elementes 17a eingeschoben, welches hinsichtlich seiner Funktion und Anordnung in bezug auf die übrigen Teile der Vorrichtung dem rohrartigen Element 17 der Fig. 1-3 entspricht. Die MELF-Bauelemente 1 sind hierbei wiederum an ihren gegen die Platten 6 anliegenden stirnseitigen Kontaktflächen 3 mit dem Leit-Kleber versehen, so daß eine Verbindung zwischen jeder Kontaktfläche 3 und der unmittelbar benachbarten Platte 6 zustande kommt. Der Kanal 16 weist (ausgehend von seinem dem Transportelement 9 benachbart liegenden Ende) über eine bestimmte Länge die stegartigen Vorsprünge 22 auf, so daß über diese Länge durch die stegartigen Vorsprünge 22 die Platten 6 sowie die MELF-Bauteile 1 in der richtigen Orientierung auch in bezug zueinander gehalten werden, wie dies oben bereits im Zusammenhang mit den Fig. 1-3 beschrieben wurde. Die Länge des mit den Stegen 22 versehenen Teils 16′ des Kanales 16 ist (auch unter Berücksichtgung der Abbind- oder Aushärtzeit des verwendeten Leit-Klebers sowie unter Berücksichtigung der maximal möglichen Leistung der Vorrichtung, d.h. unter Berücksichtigung der maximal je Zeiteinheit verarbeiteten Meß-Bauelemente 1) so gewählt, daß immer dann, wenn ein MELF-Bauelement 1 mit seinen zugehörigen Platten 6 durch Weiterschieben im Kanal 16 das Ende des Teiles 16' dieses Kanales erreicht hat, das MELF-Bauteil 1 bereits ausreichend fest an den zugehörigen Platten 6 durch Festkleben fixiert ist. An den Teil 16' schließt sich dann in Bewegungsrichtung der MELF-Bauteile 1 und der mit diesen verbundenen Platten 6 ein Teil 16'' des Kanales 16 an, in welchem (Teil 16'') bei sonst gleichem Querschnitt des Kanales 16 die Vorsprünge 22 fehlen. In diesen Teil 16'' mündet dann der Zuführungskanal 27, über den die den Bauelementekörper des Bauelementes 4a bildende Kunststoffmasse zugeführt wird. Nach dem Passieren dieses Zuführungskanales 27 sind dann die zwischen den Platten 6 vorgesehenen MELF-Bauteile 1 mit der Kunststoffmasse ummantelt, wobei durch den Queschnitt, den der Kanal 16 im Teil 16'' aufweist, und vor allem durch das dortige Fehlen der Vorsprünge 22 die angestrebte Querschnittsform der Bauelemente 4a ohne die Längsnuten 8 erhalten wird.

Die Bauelemente 4a lassen sich aber auch mit der Vorrichtung nach den Fig. 1-3 dadurch herstellen, daß die Ummantelung der MELF-Bauelemente 1 mit der Kunststoffmasse nicht innerhalb des Kanales 16, sondern bei abgebundenem bzw. ausgehärtetem Leitkleber und damit bei mit den Platten 6 verbundenem MELF-Bauteilen 1 außerhalb des Kanales 16 und bevorzugt durch Formen unter Druck in einer gesonderten Form erfolgt, die die Flächenbereiche 5 formende ebene Formflächen aufweist.

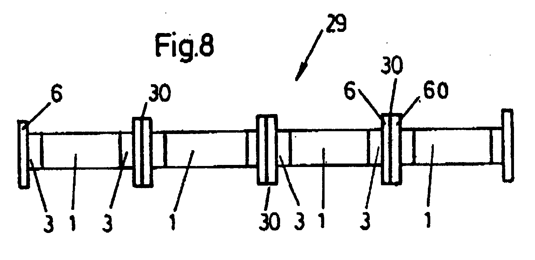

Entsprechend Fig. 8 wird hierbei dann bevorzugt so vorgegangen, daß unter Verwendung der Vorrichtung nach den Fig. 1-3 ein stangenartiger Rohling 29 hergestellt wird, in welchem auf jedes MELF-Bauelement 1 jeweils zwei Platten 6 folgen und welche an beiden Enden mit jeweils einer Platte 6 abschließt. Jede Platte 6 ist wiederum mit Hilfe des Leit-Klebers mit der stirnseitigen Kontaktfläche 3 an einem Ende eines MELF-Bauelementes 1 verbunden. Außerdem sind in dem stangenartigen Rohling 29 auch die unmittelbar aufeinanderfolgenden Platten 6 an ihren einander zugewendeten Oberflächenseiten durch ein Verbindungsmittel miteinander verbunden, wie dies in der Fig. 8 durch die dort allerdings übertrieben dick dargestellten Schichten 30 dieses Verbindungsmittels angedeutet ist. Der Rohling 28 wird dann als Ganzes in eine Form eingesetzt, in der die den Bauelementekörper der Bauelemente 4a bildende Kunststoffummantelung aufgebracht wird, und zwar vorzugsweise wiederum durch Formen unter Druck. Im Anschluß daran wird der stangenartige Rohling 29 in die einzelnen Bauelemente 4a zertrennt, und zwar an den Verbindungsstellen zwischen den Platten 6 (Schichten 30). Das Verbindungsmittel ist dabei ein solches, welches beispielsweise unter Erwärmung ein Zertrennen des Rohlings 29 in die einzelnen Bauelemente 4a leicht zuläßt. Als Verbindungsmittel kann beispielsweise Wachs oder ein unter Wärmeeinwirkung weich werdender Kunststoff oder Kleber verwendet werden. Bevorzugt ist das Verbindungsmittel allerdings ein Lot mit niedrigem Schmelzpunkt, so daß durch dieses Verbindungsmittel gleichzeitig auch eine Verzinnung der Platten 6 an ihren freiliegenden Flächen erreicht wird. Bei dieser Ausführung sind dann bevorzugt bereits die Metall- bzw. Materialstreifen 23 und 24 an ihren einander zugewendeten Flächen mit diesem Verbindungsmittel miteinander verbunden.

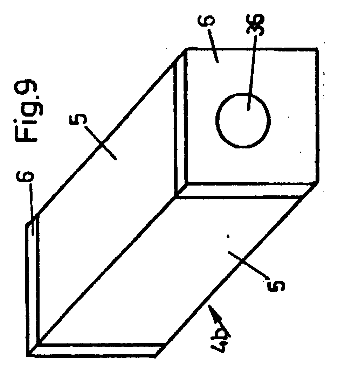

Fig. 9 zeigt in perspektivischer Darstellung ein durch Umformen unter Verwendung eines MELF-Bauelementes 1 erhaltenes Bauelement 4b, welches in gleicher Weise wie das Bauelement 4a an den Flächenbereichen 5 seines Bauelementekörpers die Längsnuten 8 nicht aufweist, bei dem jedoch auch die Platten 6 die Aussparungen 7 nicht besitzen.

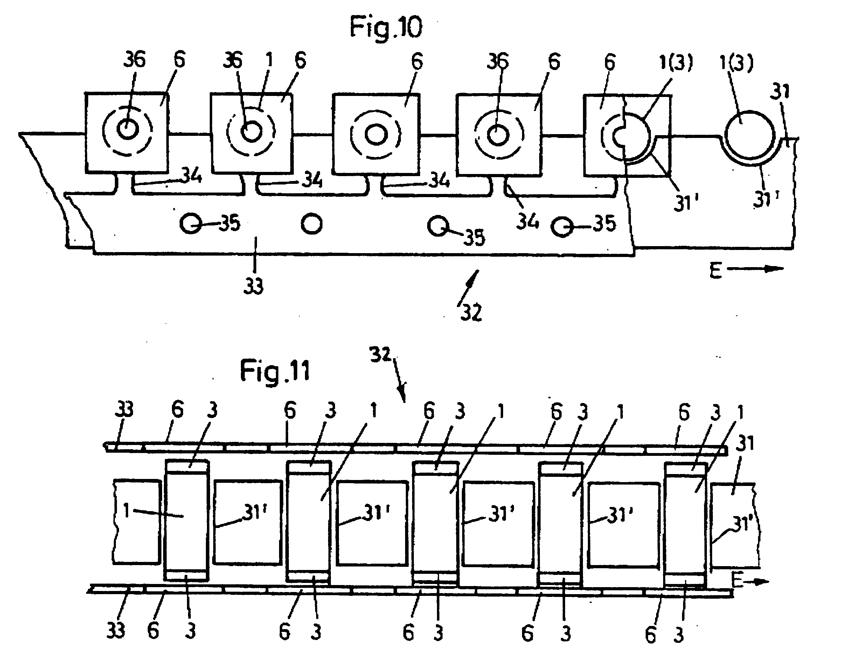

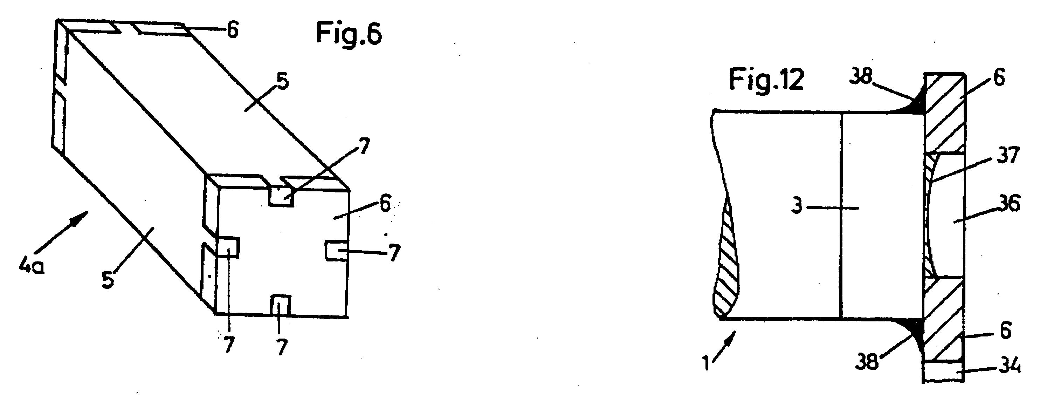

Zur Herstellung dieses Bauelementes 4b werden die MELF-Bauelemente 1 über ein Transportelement 31 einer Arbeitsstation 32 zugeführt. Das Transportelement 31 besitzt Aufnahmen 31′ für die MELF-Bauelemente 1 in der Form, daß jedes MELF-Bauelement 1 mit seiner Längsachse senkrecht zur Förderrichtung E des Transportelementes 31 liegt und benachbarte MELF-Bauelemente 1 am Transportelement 31 in Transportrichtung E jeweils einen gleichen, vorgegebenen Abstand voneinander aufweisen. Das Transportelement 31, welches bei der in den Fig. 10-12 dargestellten Ausführungsform ein Transportband oder ein Transportriemen ist, ist weiterhin so ausgebildet, daß die MELF-Bauelemente 1 mit ihren die stirnseitigen Kontaktflächen 3 aufweisenden Enden jeweils über die Längsseiten dieses Transportelementes 31 wegstehen.

Immer dann, wenn eine bestimmte Anzahl von MELF-Bauelementen 1 die Arbeitsstation 32 erreicht hat, wird die Bewegung des Transportelementes 31 gestoppt. An der Arbeitsstation 32 steht dann auch eine der Anzahl der MELF-Bauelemente 1 entsprechende Anzahl von Platten 6 bereit, und zwar an jedem die stirnseitige Kontaktfläche 3 aufweisenden Ende jedes MELF-Bauelementes 1 eine derartige Platte, die mit ihrer Ebene senkrecht zur Längserstreckung des jeweiligen MELF-Bauelementes 1 liegt. Die Platten 6 sind dabei am Trägerstreifen 33 vorgesehen, die der Arbeitsstation 32 so zugeführt werden, daß an dieser Arbeitsstation sich jeweils ein derartiger Trägerstreifen 33 befindet, an welchem die Platten 6 in Längsrichtung des Trägerstreifens in dem gleichen Abstand vorgesehen sind, den die MELF-Bauelemente 1 auf dem Transportelement 31 aufweisen. Bei der dargestellten Ausführungsform sind die Platten 6 über Stege 34 an einer Längsseite des jeweiligen Trägerstreifens 33 derart befestigt, daß die Platten 6 über diese Längsseite des Trägerstreifens 33 wegstehen, wobei die Platten 6, der Trägerstreifen 33 sowie die Stege 34 einstückig aus dem gleichen Material (Metallblech) hergestellt sind. In dem jeweiligen Trägerstreifen 33 sind eine Perforation bildende Öffnungen 35 vorgesehen, mit denen es möglich ist, die Trägerstreifen 33 an die Arbeitsstation 32 so zuzuführen, daß bei in seiner Bewegung gestopptem Transportelement 31 jede Platte 6 exakt einem stirnseitigen Ende eines MELF-Bauelementes 1 benachbart liegt, und zwar insbesondere auch so, daß die Längsachse jedes MELF-Bauelementes 1 die Mittelpunkte der beiden, den Enden dieses MELF-Bauteils 1 benachbarten Platten 6 schneidet.

Die einzelnen, sich in der Arbeitsstation 32 befindlichen MELF-Bauelemente 1 werden dann an ihren beiden stirnseitigen Kontaktflächen 3 mit der zugehörigen Platte 6 verbunden, was auch bei dieser Ausführungsform bevorzugt wiederum mit Hilfe eines Kontakt-Klebers erfolgt, welcher entweder auf die stirnseitigen Kontaktflächen 3 der MELF-Bauelemente 1 aufgebracht wird, und zwar bevorzugt bevor diese MELF-Bauelemente 1 die Arbeitsstation 32 erreichen, oder aber auf die Platten 6 aufgebracht wird, und zwar bevorzugt bevor diese die Arbeitsstation 32 erreichen. Der Leit-Kleber kann dabei ein durch UV-Licht aushärtbarer Kleber sein. In diesem Fall besitzen die Platten 6 in ihrer Mitte eine Öffnung 36, in den der beim Andrücken der Platten 6 gegen die jeweilige Kontaktfläche 3 teilweise hineinfließt, so daß sich im Bereich jeder Öffnung 36, aber auch am Umfang der stirnseitigen Kontaktflächen 3 Kleberbereiche 37 und 38 zwischen jeder Platte 6 und dem MELF-Bauelement 1 ergeben, die (Kleberbereiche) freiliegen und mit dem UV-Licht ausgehärtet werden können.

Sobald die in der Arbeitsstation 32 befindlichen MELF-Bauelemente 1 mit den Platten 6 der beiden Trägerstreifen 33 verbunden sind, d.h. bei Verwendung eines Leit-Klebers nach dem Aushärten dieses Klebers, wird die entsprechende Länge von jedem Trägerstreifen 33 abgetrennt. Der so erhaltene Rohling, der aus zwei parallelen Längen der Trägerstreifen 33 mit den daran vorgesehenen Platten 6 und den an diesen Platten befestigten MELF-Bauelementen 1 besteht, wird dann in eine Form eingebracht, in der die MELF-Bauelemente 1 in der Kunststoffmasse eingebettet bzw. vorzugsweise unter Druck die Bauelementekörper der einzelnen Bauelemente 4b geformt werden. Nach diesem Formprozeß werden die einzelnen Bauelemente 4b von den beiden Trägerstreifenlängen abgetrennt, und zwar bei der dargestellten Ausführungsform durch Zertrennen der Stege 34. Bei der vorbeschriebenen Ausführungsform wird somit in jedem Arbeitsgang eine Vielzahl von Bauelementen 4b gleichzeitig erhalten. Grundsätzlich ist es natürlich auch möglich, daß in jedem Arbeitsgang jeweils nur ein MELF-Bauelement 1 an seinen beiden stirnseitigen Kontaktflächen 3 mit jeweils einer Platte 6 versehen und anschließend der Form zum Einschließen des MELF-Bauelementes 1 in die Kunststoffmasse sowie zur Bildung des Bauelementekörpers des Bauelementes 4b zugeführt wird.

Die Erfindung wurde voranstehend an Ausführungsbeispielen beschrieben. Es versteht sich, daß weitere Änderungen sowie Abwandlungen möglich sind, ohne daß dadurch der die Erfindung tragende Gedanke verlassen wird.

## Patentansprüche

1. Verfahren zum Umformen von zylindrischen elektrischen Bauteilen in elektrische Bauelemente bzw. SMDs, deren Umfangsfläche wenigstens einen ebenen Flächenabschnitt aufweist, wobei an den stirnseitigen kontaktflächen (3) des Bauteils (1) jeweils eine in ihrem Umfang dem Umfangsquerschnitt des umgeformten Bauelementes (4, 4a, 4b) entsprechende Platte (6) aus Metall derart befestigt wird, daß die beiden Platten (6) mit ihren Oberflächenseiten senkrecht zur Längserstreckung des Bauteiles (1) liegen und zumindest mit dem den ebenen Flächenbereich (5) des durch Umformung erhaltenen Bauelementes (4, 4a, 4b) entsprechenden Teilbereich ihrer Umfangsfläche in gleicher Orientierung radial über die Umfangsfläche des Bauteiles (1) wegstehen, und
wobei der Bereich zwischen den Platten (6) mit einer die äußere Umfangsfläche des umgeformten Bauelementes (4, 4a, 4b) bildenden, aushärtenden Masse aus elektrisch isolierendem Material, beispielsweise Kunststoff derart ausgefüllt wird, daß diese Masse den wenigstens einen ebenen Flächenbereich des umgeformten Bauelementes (4, 4a, 4b) bildet.

2. Verfahren nach Anspruch 1, dadurch gekennzeichnet, daß vor dem Ausfüllen des zwischen den Platten (6) liegenden Bereichs mit dem elektrisch isolierenden Material die Platten (6) an dem Bauteil vorzugsweise unter Verwendung eines Leit-Klebers festgelegt werden.

3. Verfahren nach Anspruch 1 oder 2, dadurch gekennzeichnet, daß der Bereich zwischen den Platten (6) derart mit der elektrisch isolierenden Masse ausgefüllt wird, daß an dem wenigstens einen ebenen Flächenbereich (5) des Bauelementes (4, 4a, 4b) die beiden Platten (6) mit ihrem diesem Flächenbereich (5) entsprechenden Teilbereich ihrer Umfangsfläche freiliegend vorgesehen sind.

4. Verfahren nach einem der Ansprüche 1 bis 3, dadurch gekennzeichnet, daß die Platten (6) in ihren Abmessungen größer sind als der Querschnitt des umzuwandelnden Bauteils (1) und so an dem Bauteil (1) befestigt werden, daß sie jeweils an ihrem gesamten Umfang radial über den Umfang des Bauteils (1) wegstehen, und daß die Masse aus elektrisch isolierendem Material so aufgebracht wird, daß das Bauteil (1) vollständig von dieser Masse umschlossen ist.

5. Verfahren nach einem der Ansprüche 1 bis 4, dadurch gekennzeichnet, daß in einen Form- oder Formierungsraum (16) zunächst wenigstens eine Platte (6), daran anschließend ein umzuwandelndes Bauteil (1) und daran anschließend wenigstens eine weitere Platte (6) derart eingebracht werden, daß das Bauteil (1) in dem Form- oder Formierungsraum (16) mit Abstand von der das Bauteil (1) sowie die Platten (6) umschließenden Wandung (18-21) des Form- oder Formierungsraumes gehalten ist.

6. Verfahren nach Anspruch 5, dadurch gekennzeichnet, daß die Platten (6) an ihrer nach dem Einbringen in den Form- oder Formierungsraum (16) den Enden des Bauteils (1) unmittelbar benachbart liegenden Flächen oder das Bauteil (1) an seinen beiden Enden vor dem Einbringen in den Form-oder Formierungsraum (16) jeweils mit einem eine Klebeverbindung zwischen den Platten (6) und dem Bauteil (1) herstellenden Auftrag versehen werden.

7. Verfahren nach Anspruch 5 oder 6, dadurch gekennzeichet, daß in den Formraum (16) die Masse aus elektrisch isolierendem Material eingebracht wird.

8. Verfahren nach einem der Ansprüche 1 - 4, dadurch gekennzeichnet, daß zunächst ein Rohling (29) hergestellt wird, der aus wenigstens zwei umzuwandelnden Bauteilen (1) mit jeweils zwei an den Anschlüssen (3) dieser Bauteile (1) festgelegten Platten (6) besteht, daß dann in einer Form oder in einem Formraum der Bereich zwischen den Platten (6) der Bauteile (1) mit dem elektrisch isolierenden Material ausgefüllt wird, und daß die wenigstens zwei Bauteile (1) über die Platten (6) zu dem Rohling (29) verbunden sind.

9. Verfahren nach Anspruch 8, dadurch gekennzeichnet, daß die wenigstens zwei Bauteile (1) des Rohlings (29) in einer senkrecht zu den Platten (6) verlaufenden Achsrichtung hintereinander vorgesehen sind und die beiden, zwischen zwei Bauteilen (1) liegenden Platten (6) trennbar miteinander verbunden sind.

10. Verfahren nach Anspruch 8, dadurch gekennzeichnet, daß die wenigstens zwei Bauteile (1) des Rohlings mit ihrer Längserstreckung parallel zueinander angeordnet sind und die Platten (6) an dem einen Ende (3) der Bauteile (1) durch einen ersten Trägerstreifenabschnitt (33) und an dem anderen Ende (3) der Bauteile (1) durch einen zweiten Trägerstreifenabschnitt (33) miteinander verbunden sind.

11. Verfahren nach Anspruch 5 - 9, dadurch gekennzeichnet, daß das Bauteil (1) durch an der Fläche (18, 21) des Form- oder Formierungsraumes (16) vorgesehenen Vorsprünge, insbesondere leistenartige Vorsprünge (22) im Abstand von dieser Fläche zumindest solange gehalten wird, bis eine Verbindung zwischen dem Bauteil (1) den zugehörigen Platten (6) erhalten ist.

12. Verfahren nach einem der Ansprüche 5 - 11, dadurch gekennzeichnet, daß als Form- oder Formierungsraum ein Kanal (16) verwendet wird, in dessen eines, offenes Ende abwechselnd jeweils zwei paketartig aufeinander liegende Platten (6) und ein Bauteil (1) eingebracht werden, und daß die so im Inneren des Kanales (16) gebildete Folge aus umzuwandelnden Bauteilen (1) und Platten (6) von dem einen Ende des Kanales (16) zu einem anderen ebenfalls offenen Ende dieses Kanales bewegt wird.

13. Verfahren nach Anspruch 12, dadurch gekennzeichnet, daß in einen zwischen diesen beiden Enden liegenden Abschnitt des Kanales (16) die den wenigstens einen ebenen Flächenbereich bildende Masse aus elektrisch isolierendem Material eingebracht wird.

14. Verfahren nach einem der Ansprüche 1 - 13, dadurch gekennzeichnet, daß die Platten (6) durch Abtrennen eines jeweils vorderen Abschnittes wenigstens eines Materialstreifens (23, 24) hergestellt werden.

15. Verfahren nach Anspruch 14, dadurch gekennzeichnet, daß zum Herstellen der Platten (6) die jeweils vorderen Abschnitte zweier, paketartig aufeinander liegender Materialstreifen (23, 24) abgetrennt werden.

16. Verfahren nach Anspruch 14, dadurch gekennzeichnet, daß zum Herstellen der Platten (6) die jeweils vorderen Abschnitte zweiter, paketartig aufeinanderliegender Materialstreifen (23, 24) abgetrennt werden, die an ihren einander zugewendeten Oberflächenseiten lösbar miteinander verbunden sind.

17. Verfahren nach einem der Ansprüche 14 - 16, dadurch gekennzeichnet, daß die Platten (6) unmittelbar nach dem Abtrennen von dem wenigstens einen Materialstreifen (23, 24) in einen den Form- oder Formierungsraum bildenden Kanal (16) eingeschoben werden.

18. Verfahren nach einem der Ansprüche 1 - 13, dadurch gekennzeichnet, daß wenigstens zwei Trägerstreifen (33) sowie wenigstens jeweils ein umzuformendes Bauteil (1) einer Bearbeitungsstation (32) derart zugeführt werden, daß das wenigstens eine Bauteil (1) mit seinen Enden (3) zwischen einer Platte (6) am einen Trägerstreifen (33) und einer Platte (6) am anderen Trägerstreifen (33) liegt, und anschließend die den Enden (3) des wenigstens einen Bauteils (1) benachbarten, an den Trägerstreifen (33) vorgesehenen Platten (6) an diesen Enden (3) festgelegt werden.

19. Verfahren nach Anspruch 18, dadurch gekennzeichnet, daß die Trägerstreifen (33) sowie die Bauteile (1) der Arbeitsstation (32) derart zugeführt werden, daß nach dem Zuführen jeweils wenigstens zwei Bauteile (1) zwischen jeweils zwei Platten (6) der beiden Trägerstreifen (33) angeordnet sind.

20. Vorrichtung zum Durchführen des Verfahrens nach einem der Ansprüche 1 bis 19, gekennzeichnet durch ein, vorzugsweise getaktet angetriebenes Transportelement (9, 31) mit wenigstens einer Aufnahme (11) zum Transportieren jeweils eines umzuwandelnden Bauteils (1) von einer Aufgabeposition an eine Arbeitsposition (32) sowie durch Mittel an der Arbeitsstation zum Zuführen und Anbringen der Platten (6) an dem jeweils umzuwandelnden Bauteil (1).

21. Vorrichtung nach Anspruch 20, dadurch gekennzeichnet, daß die wenigstens eine Aufnahme (11) so ausgebildet ist, daß das umzuwandelnde Bauteil (1) mit seiner Längserstreckung quer bzw. senkrecht zur Förderrichtung (A, E) des Transportelementes (9, 31) liegt.

22. Vorrichtung nach Anspruch 20 oder 21, dadurch gekennzeichnet, daß das Transportelement (9, 31) in Transportrichtung (A, E) getaktet angetrieben ist.

23. Vorrichtung nach einem der Ansprüche 20 - 22, dadurch gekennzeichnet, daß das Transportelement (9, 31) ein umlaufendes, mit der wenigstens einen Aufnahme (11) versehenes transportbandartiges Element oder ein umlaufend angetriebenes rad- bzw. ringartiges Element ist.

24. Vorrichtung nach einem der Ansprüche 20 - 23, dadurch gekennzeichnet, daß an der Arbeitsposition Form- oder Formierungsraum, vorzugsweise in Form eines Kanales (16) gebildet ist und Mittel zum Einbringen der Platten (6) und des jeweils umzuwandelnden Bauteils (1) in den Form-oder Formierungsraum vorgesehen sind.

25. Vorrichtung nach Anspruch 24, dadurch gekennzeichnet, daß der Form- oder Formierungsraum (16) an einer in Transportrichtung (A) des Transportelementes liegenden Seite dieses Transportelementes (9) vorgesehen ist und eine Öffnung aufweist, die dann, wenn die wenigstens eine Aufnahme (11) die Arbeitsposition erreicht, deckungsgleich mit der Aufnahme (11) liegt.

26. Vorrichtung nach einem der Ansprüche 20 bis 25, dadurch gekennzeichnet, daß Mittel vorgesehen sind, um der Arbeitsposition an der dem Form- oder Formierungsraum (16) gegenüberliegenden Seite wenigstens einen Materialstreifen (23, 24) zuzuführen und von diesem Materialstreifen jeweils einen vorderen Abschnitt als Platte (6) abzutrennen und in den Form- oder Formierungsraum (16) einzuschieben.

27. Vorrichtung nach Anspruch 26, dadurch gekennzeichnet, daß Mittel vorgesehen sind, um der Arbeitsposition zwei paketartig aufeinander liegende Materialstreifen (23, 24) zuzuführen und/oder einen Kleber auf die beiden Enden des jeweils umzuwandelnden Bauteis (1) und/oder auf eine Oberflächenseite der Platten (6) aufzubringen.

28. Vorrichtung nach einem der Ansprüche 24 - 27, dadurch gekennzeichnet, daß der Querschnitt des Form- oder Formierungsraumes (16) gleich dem Umfangsquerschnitt der Platten (6) ist.

29. Vorrichtung nach einem der Ansprüche 24 - 28, dadurch gekennzeichnet, daß in den Form- oder Formierungsraum bzw. in den Kanal (16), dessen eines, offenes Ende dem Transportelement (9) benachbart liegt, wenigstens ein weiterer Kanal (27) zum Zuführen der Masse aus elektrisch isolierendem Material mündet.

30. Vorrichtung nach einem der Ansprüche 24 - 29, dadurch gekennzeichnet, daß an den Form- oder Formierungsraum begrenzenden Wandflächen (18-21) in diesen Form- oder Formierungsraum (16) hineinreichende Vorsprünge, vorzugsweise leistenartige Vorsprünge (22) vorgesehen sind, und der Abstand, den die freien Enden einander gegenüberliegender Vorsprünge (22) von einander aufweisen an den Durchmesser des umzuwandelnden Bauteils (1) angepaßt ist.

31. Vorrichtung nach einem der Ansprüche 24 - 30, gekennzeichnet durch einen senkrecht zur Transportrichtung (A) des Transportelementes (9) hin- und herbewegbaren Schneidstempel zum Abtrennen der Platten (6) von dem wenigstens einem Materialstreifen (23, 24) sowie zum Einschieben dieser Platten (6) in den Form- oder Formierungsraum (16).

32. Vorrichtung nach einem der Ansprüche 20 - 31, dadurch gekennzeichnet, daß an der Arbeitsposition (32) Mittel zum Zuführen wenigstens eines Trägerstreifens (33) vorgesehen sind, der in Trägerstreifenlängsrichtung aufeinanderfolgend mit den Platten (6) versehen ist.

33. Vorrichtung nach einem der Ansprüche 20 - 32, gekennzeichnet durch eine Einrichtung zum Aufbringen eines Klebers auf die beiden Enden des umzuwandelnden Bauteils (1) und/oder auf eine Oberflächenseite der Platten (6).

## Claims

1. A method of converting cylindrical electrical components into electrical structural elements or SMDs, the peripheral face of which has at least one flat surface portion, wherein one respective plate (6) of metal corresponding in its periphery to the peripheral cross-section of the converted structural element (4, 4a, 4b) is secured to the end contact faces (3) of the component (1) in such a way that the two plates (6) lie with the surface sides thereof at right angles to the longitudinal extension of the component (1) and project with the same orientation radially beyond the peripheral face of the component (1) at least with the partial area of their peripheral face corresponding to the flat surface area (5) of the structural element (4, 4a, 4b) obtained by conversion, and the region between the plates (6) is filled with a hardening mass of electrically insulating material, for example plastics material, forming the outer peripheral face of the converted structural element (4, 4a, 4b), in such a way that the said mass forms the at least one flat surface area of the converted structural element (4, 4a, 4b).

2. A method according to claim 1, characterised in that before the area lying between the plates (6) is filled with the electrically insulating material the plates (6) are secured to the component using a conducting adhesive.

3. A method according to claim 1 or 2, characterised in that the region between the plates (6) is filled with the electrically insulating mass in such a way that on the at least one flat surface area (5) of the structural element (4, 4a, 4b) the two plates (6) are provided with their partial area of their face - corresponding to the said surface area (5) - bare.

4. A method according to one of claims 1 to 3, characterised in that the plates (6) are larger in their dimensions than the cross-section of the component (1) to be converted and are secured to the component (1) in such a way that they each project with their entire periphery radially beyond the periphery of the component (1), and the mass of electrically insulating material is applied in such a way that the component (1) is completely surrounded by the said mass.

5. A method according to one of claims 1 to 4, characterised in that first at least one plate (6), then a component (1) to be converted and then at least one further plate (6) are inserted into a mould space or moulding space (16) in such a way that the component (1) is held in the mould space or moulding space (16) at a distance from the wall (18-21) of the mould space or moulding space enclosing the component (1) and the plates (6).

6. A method according to claim 5, characterised in that the plates (6) are provided on their faces situated directly adjacent to the ends of the component (1) after insertion into the mould space or moulding space (16) or the component (1) is provided at its two ends before insertion into the mould space or moulding space (16) respectively with a coating producing an adhesive join between the plates (6) and the component (1).

7. A method according to claim 5 or 6, characterised in that the mass of electrically insulating material is introduced into the mould space (16).

8. A method according to one of claims 1 to 4, characterised in that first a blank (29) is produced which comprises at least two components (1) to be converted and each with two plates (6) secured to the terminals (3) of the said components (1), then the area between the plates (6) of the components (1) is filled with the electrically insulating material in a mould or in a mould space, and the at least two components are joined to the blank (29) by way of the plates (6).

9. A method according to claim 8, characterised in that the at least two components (1) of the blank (29) are provided one behind the other in an axial direction extending at right angles to the plates (6), and the two plates (6) situated between two components (1) are separably joined to each other.

10. A method according to claim 8, characterised in that the at least two components (1) of the blank are arranged with their longitudinal extensions parallel to one another, and the plates (6) are connected to each other by a first support-strip portion (33) at one end (3) of the components (1) and by a second support-strip portion (33) at the other end (3) of the components (1).

11. A method according to one of claims 5 to 9, characterised in that the component (1) is held at a distance from the face (18, 21) of the mould space or moulding space (16) by projections, in particular strip-like projections (22), provided on the said face (18, 21) at least until a join is formed between the component (1) and the associated plates (6).

12. A method according to one of claims 5 to 11, characterised in that a duct (16) is used as the mould space or moulding space, wherein two plates (6) lying one upon the other in the manner of a stack and a component (1) are alternately inserted respectively into one open end of the said duct (16), and the sequence of components (1) to be converted and plates (6) formed in this way in the interior of the duct (16) is moved from one end of the duct (16) to another likewise open end of the said duct.

13. A method according to claim 12, characterised in that in a section of the duct (16) located between both the ends, the mass of electrically insulating material forming at least one flat surface position is inserted.

14. A method according to one of claims 1-13, characterised in that the plates (6) are produced by the cutting off of a respective frontal section at least of a material strip (23, 24).

15. A method according to claim 14, characterised in that for the production of the plates (6), the respective frontal sections are cut off from two material strips (23, 24), lying stack-like one on top of the other.

16. A method according to claim 14, characterised in that for the production of the plates (6), the respective frontal sections are cut off from two material strips (23, 24), lying stack-like one on top of the other, removably connected on their facing surface sides.

17. A method according to one of claims 14-16, characterised in that the plates (6) are moved into position in the duct formed mould space or moulding space immediately after the cutting off from the at least a material strip (23, 24).

18. A method according to one of claims 1-13, characterised in that at least two support strips (33) as well as at least respectively a component (1) to be transformed are fed to a processing station (32) in such a way that the at least a component (1) lies with its ends (3) between a plate (6) on one support strip (33) and a plate (6) on the other support strip (33) and subsequently the plates (6) provided on the support strip (33) are fixed on these ends (3) to the ends (3) of at least a neighbouring component (1).

19. A method according to claim 18, characterised in that the support strip (33) as well as the component (1) are fed to the processing station (32) in such a way that following the supply respectively at least two components (1) are arranged between each two plates (6) of both support strips (33).

20. Apparatus for the implementation of the method according to one of claims 1-19, characterised in a, preferably clock driven transport element (9, 31) with at least a receptacle (11) to transport each a component (1) to be converted from a feeding position to a processing position (32) as well as in means on the processing station to supply and fasten the plates (6) on each component (1) to be transformed.

21. Apparatus according to claim 20, characterised in that the at least a receptacle (11) is so constructed that the component (1) to be transformed lies with its longitudinal extension crossways or perpendicular to the conveyor direction (A, E) of the transport elements (9, 31).

22. Apparatus according to claims 20 or 21, characterized in that the transport element (9, 31) is clock driven in the transport direction (A, E).

23. Apparatus according to one of claims 20-22, characterised in that the transport element (9, 31) is a circulating transport belt-like element with the at least a receptacle provided, or a circulating driven wheel or ring like element.

24. Apparatus according to one of claims 20-23, characterised in that a mould space or moulding space, preferably in the form of a duct (16), is formed at the processing position and means are provided to insert the plates (6) and the respective components (1) to be transformed into the mould space or moulding space.

25. Apparatus according to claim 24, characterised in that the mould space or moulding space (16) is provided with and displays an opening against a side of the transport element (9) lying in the transport direction (A) of the transport element, that will be congruent with the receptacle (11) if the at least a receptacle (11) reaches the processing position.

26. Apparatus according to one of claims 20-25, characterised in that means are provided, around the processing position, on the side facing the mould space or moulding space, to supply at least a material strip (23, 24) and to detach from this material strip respectively a frontal section as a plate (6) and to insert it into the mould space or moulding space.

27. Apparatus according to claim 26, characterised in that means are provided, around the processing position, to supply two material strips (23, 24) lying stack-like one on top of the other, and/or an adhesive on both ends of the respective components (1) to be transformed and/or to place the plates (6) on a surface side.

28. Apparatus according to one of claims 24-27, characterised in that the cross section of the mould space or moulding space (16) is the same as the peripheral cross section of the plates (6).

29. Apparatus according to one of claims 24-28, characterised in that in the mould space or moulding space or in the duct (16), which an open end of the transport element (9) neighbours, at least a further duct (27) leads in to supply the mass of electrically insulating material.

30. Apparatus according to one of claims 24-29, characterised in that on the mould space or moulding space limiting wall surfaces (18-21), projections extending into this mould space or moulding space (16), preferably strip-like projections (22) are provided, and the distance to the free ends from each other, each other showing facing projections (22), is adjusted to the diameter of the component to be converted.

31. Apparatus according to one of claims 24-30, characterised through a cutting punch, perpendicular to the transport direction (A) of the transport element (9), movable to and fro, to cut off the plates (6) from the at least a material strip (23, 24) as well as to insert these plates (6) in the mould space or moulding space (16).

32. Apparatus according to one of claims 20-31, characterised in that on the processing position (32) means are prodded to supply at least a support strip (33), with the plates (6) following one another in the support strip length extension.

33. Apparatus according to one of claims 20-32, characterised through a device to deposit an adhesive on both ends of the component (1) to be transformed and/or on a surface side of the plates (6).

## Revendications

1. Procédé pour transformer des composants électriques cylindriques en éléments électriques ou SMDs dont la surface périphérique comporte au moins une partie superficielle plane, une plaque (6) en métal correspondant quant à son pourtour à la section du pourtour de l'élément transformé (4, 4a, 4b) étant chaque fois fixée aux surfaces de contact frontales (3) du composant (1) de manière telle que les deux plaques (6) sont disposées avec leurs faces perpendiculairement à l'étendue longitudinale du composent (1) et font saillie au moins avec la région partielle de leur surface périphérique correspondant à la région superficielle plane (5) de l'élément (4, 4a, 4b) obtenu par transformation, avec la même orientation radialement au-delà de la surface périphérique du composant (1) et la région entre les plaques (6) étant remplie d'une matière durcissante, électriquement isolante, par exemple d'une matière plastique, formant la surface périphérique extérieure de l'élément transformé (4, 4a, 4b) de manière telle que cette matière forme la région superficielle plane (au moins une) de l'élément transformé (4, 4a, 4b).

2. Procédé selon la revendication 1 caractérisé en ce qu'avant le remplissage de la région disposée entre les plaques (6) avec la matière électriquement isolante, on fixe les plaques (6) sur le composant en utilisant de préférence une colle conductrice.

3. Procédé selon la revendication 1 ou 2 caractérisé en ce que la région entre les plaques (6) est remplie de la matière électriquement isolante de manière telle que les deux plaques (6) sont prévues avec la région partielle de leur surface périphérique correspondant à la région plane (5) disposée librement près de cette région superficielle plane (5) (au moins une) de l'élément (4, 4a, 4b).

4. Procédé selon la revendication 1 à 3 caractérisé en ce que les plaques (6) sont plus grandes quant à leurs dimensions que la section du composent (1) à transformer et elles sont fixées sur le composent (1) de manière telle qu'elles font chacune saillie radialement sur tout leur pourtour au-delà du pourtour du composent (1) et le matériau électriquement isolant est mis en place de manière telle que le composant (1) est entièrement entouré par ce matériau.

5. Procédé selon l'une des revendications 1 à 4 caractérisé en ce que l'on met en place dans un compartiment ou espace de moulage ou de formage (16) d'abord au moins une plaque (6), ensuite un composant (1) à transformer et ensuite au moins une autre plaque (6) de manière telle que le composant (1) soit maintenu, dans le compartiment de moulage ou de formage, à distance de la paroi (18-21) du compartiment de moulage ou de formage entourent le composant (1) ainsi que les plaques (6).

6. Procédé selon la revendication 5 caractérisé en ce qu'on munit les plaques (6) à leurs surfaces disposées, après introduction dans le compartiment de moulage ou de formage (16), immédiatement au voisinage des extrémités du composent (1), ou le composant (1) à ses deux extrémités avant introduction dans le compartiment de moulage ou de formage (16) chaque fois d'un enduit réalisant une jonction par collage entre les plaques (6) et le composent (1).

7. Procédé selon la revendication 5 ou 6 caractérisé en ce qu'on introduit la matière électriquement isolante dans le compartiment de moulage (16).

8. Procédé selon l'une des revendications 1 à 4 caractérisé en ce qu'on fabrique d'abord une pièce brute (29) qui est constituée d'au moins deux composants (1) à transformer avec chaque fois deux plaques (6) fixées aux raccordements (3) de ces composants (1), on remplit ensuite, dans un moule ou dans un compartiment de moulage, la région entre les plaques (6) des composants (1) de la matière électriquement isolante et les composants (1) qui sont au moins deux sont assemblés en une pièce brute (29) par l'intermédiaire des plaques (6).

9. Procédé selon la revendication 8 caractérisé en ce que les composants (1) (au moins deux) de la pièce brute (29) sont prévus disposés l'un derrière l'autre suivant une direction axiale perpendiculaire aux plaques (6) et les deux plaques (6) disposées entre deux composants (1) sont assemblées ensemble de manière séparable.

10. Procédé selon la revendication 8 caractérisé en ce que les composants (1) (au moins deux) de la pièce brute sont disposés parallèlement l'un à l'autre avec leur étendue longitudinale et les plaques (6) sont assemblées ensemble a l'une des extrémités (3) des composants (1) par un segment de bande de support (33) et a l'autre extrémité (3) des composants (1) par un deuxième segment de bande de support (33).

11. Procédé selon la revendication 5 à 9 caractérisé en ce que le composant (1) est maintenu a distance de la surface (18, 21) du compartiment de moulage ou de formage (16) par des saillies, en particulier des saillies (22) sous forme de bandes, prévues sur cette surface du compartiment de moulage ou de formage (16), au moins jusqu'a ce que l'on obtienne une jonction entre le composant (1) et les plaques correspondantes (6).

12. Procédé selon l'une des revendications 5 à 11 caractérisé en ce qu'on utilise comme compartiment de moulage ou de formage un canal (16) dans une extrémité ouverte duquel on introduit alternativement chaque fois deux plaques (6) placées l'une sur l'autre a la manière d'un paquet et un composant (1) et la succession de composants (1) a transformer et de plaques (6) formée a l'intérieur du canal (16) est déplacée de l'une des extrémités du canal (16) à une autre extrémité également ouverte de ce canal.

13. Procédé selon la revendication 12 caractérisé en ce qu'on introduit dans une partie du canal (16) disposée entre ces deux extrémités la matière électriquement isolante formant la région superficielle plane (au moins une).

14. Procédé selon l'une des revendications 1 à 13 caractérisé en ce que les plaques (6) sont produites par séparation de chaque fois une partie avant d'au moins une bande de matériau (23, 24).

15. Procédé selon la revendication 14 caractérisé en ce qu'on sépare, pour la production des plaques (6), les parties chaque fois avant de deux bandes de matière (23, 24) disposées l'une sur l'autre a la maniére d'un paquet.

16. Procédé selon la revendication 14 caractérisé en ce qu'on sépare, pour la production des plaques (6), chaque fois les parties avant de deux bandes de matière (23, 24) disposées l'une sur l'autre a la maniére d'un paquet, bandes de matière qui sont assemblées ensemble de manière amovible à leurs faces en regard l'une de l'autre.

17. Procédé selon l'une des revendications 14 à 16 caractérisé en ce qu'on introduit les plaques (6) dans un canal (16) formant le compartiment de moulage ou de formage, directement après séparation de la bande de matériau (23, 24) (au moins une).

18. Procédé selon l'une des revendications 1 à 13 caractérisé en ce qu'on amène dans une station de traitement (32) au moins deux bandes de support (33) ainsi qu'au moins chaque fois un composant (1) à transformer de manière telle que le composant (1) (au moins un) est disposé avec ses extrémités (3) entre une plaque (6) sur une bande de support (33) et une plaque (6) sur l'autre bande de support (33) et subséquemment on fixe les plaques (6) prévues sur les bandes de support (33), voisines des extrémités (3) du composant (1) (au moins un), sur ces extrémités (3).

19. Procédé selon la revendication 18 caractérisé en ce qu'on amène les bandes de support (33) ainsi que les composants (1) à la station de traitement (32) de manière telle qu'après l'amenage chaque fois au moins deux composants (1) sont disposés entre chaque fois deux plaques (6) des deux bandes de support (33).

20. Dispositif pour la mise en oeuvre du procédé selon l'une des revendications 1 à 19 caractérisé par un élément de transport (9, 31) entraîné de préférence cycliquement comportant au moins un emplacement récepteur (11) pour le transport de chaque fois un composant (1) a transformer d'une position de chargement à une position de travail (32) ainsi que par des moyens à la station de travail pour l'amenage et le montage des plaques (6) sur le composant (1) respectif à transformer.

21. Dispositif selon la revendication 20 caractérisé en ce que l'emplacement récepteur (11) (au moins un) est agencé de manière telle que le composant (1) à transformer est avec son étendue longitudinale disposé transversalement ou perpendiculairement à la direction de transport (A, E) de l'élément de transport (9, 31).

22. Dispositif selon la revendication 20 ou 21 caractérisé en ce que l'élément de transport (9, 31) est entraîné en cadence en direction de transport (A, E).

23. Dispositif selon l'une des revendications 20 à 22 caractérisé en ce que l'élément de transport (9, 31) est un élément tournant sous forme de bande de transport comportant au moins un emplacement récepteur (11) ou un élément sous forme de roue ou d'anneau entraîné de manière à tourner.

24. Dispositif selon l'une des revendications 20 à 23 caractérisé en ce qu'a la position de travail un compartiment de moulage ou de formage sous forme d'un canal (16) est formé et que des moyens sont prévus pour l'introduction des plaques (6) et du composant (1) chaque fois à transformer dans le compartiment de moulage ou de formage.

25. Dispositif selon la revendication 24 caractérisé en ce que le compartiment de moulage ou de formage (16) est prévu sur un côté de l'élément de transport (9) disposé en direction de transport (A) de cet élément de transport et il comporte une ouverture qui coïncide avec l'emplacement récepteur (11) lorsque cet emplacement récepteur (au moins un) atteint la position de travail.

26. Dispositif selon l'une des revendications 20 à 25 caractérisé en ce qu'on prévoit des moyens pour amener à la position de travail, sur le côté en face du compartiment de moulage et de formage (16), au moins une bande de matériau (23, 24) et pour séparer de cette bande de matériau chaque fois une partie avant sous forme de plaque (6) et l'introduire dans le compartiment de moulage et de formage (16).

27. Dispositif selon la revendication 26 caractérisé en ce qu'on prévoit des moyens pour amener à la position de travail deux bandes de matériau (23, 24) placées l'une sur l'autre en paquet et/ou pour appliquer un adhésif sur les deux extrémités du composant (1) chaque fois à transformer et/ou sur une face des plaques (6).

28. Dispositif selon l'une des revendications 24 à 27 caractérisé en ce que la section du compartiment de moulage ou de formage (16) est identique à la section du pourtour des plaques (6).

29. Dispositif selon l'une des revendications 24 à 28 caractérisé en ce qu'au moins un autre canal (27) pour l'amenage de la matière électriquement isolante débouche dans le compartiment de moulage ou de formage ou dans le canal (16) dont une extrémité ouverte est voisine de l'élément de transport (9).

30. Dispositif selon l'une des revendications 24 à 29 caractérisé ce qu'on prévoit des saillies, de préférence des saillies (22) sous forme de bandes, entrant dans le compartiment de moulage ou de formage (16), aux surfaces des parois (18-21) limitant le compartiment de moulage ou de formage et la distance que présentent les extrémités libres de saillies opposées (22) l'une par rapport a l'autre est adaptée au diamètre du composant (1) à transformer.

31. Dispositif selon l'une des revendications 24 à 30 caractérisé par un poinçon de coupe déplaçable alternativement perpendiculairement à la direction de transport (A) de l'élément de transport (9), destiné a séparer les plaques (6) de la bande de matériau (23, 24) (au moins une) et à introduire ces plaques (6) dans le compartiment de moulage ou de formage (16).

32. Dispositif selon l'une des revendications 24 à 29 caractérisé ce qu'on prévoit, à la position de travail (32), des moyens pour l'amenage d'au moins une bande de support (33) qui est munie en direction longitudinale de la bande de support de manière successive de plaques (6).

33. Dispositif selon l'une des revendications 20 à 32 caractérisé par une installation pour l'application d'un adhésif sur les deux extrémités du composant (1) à transformer et/ou sur une face des plaques (6).
